# EUROPÄISCHE PATENTSCHRIFT

(11) **EP 0 357 608 B1**
(45) Veröffentlichungstag und Bekanntmachung des Hinweises auf die Patenterteilung: **28.04.1993**
(21) Anmeldenummer: 88901564.0
(22) Anmeldetag: 18.02.1988
(51) Int. Cl.: H01F 17/00, H01F 27/28

(54) **HOCHFREQUENZ-BAUELEMENT**
HIGH-FREQUENCY COMPONENT
COMPOSANT DE HAUTE FREQUENCE

(30) Priorität: 13.03.1987 DE 3708209
(43) Veröffentlichungstag der Anmeldung: 14.03.1990
(73) Patentinhaber: ROBERT BOSCH GMBH, 70442 Stuttgart (DE)
(72) Erfinder: PFIZENMAIER, Heinz, D-7250 Leonberg (DE); SCHMIDT, Ewald, D-7140 Ludwigsburg (DE)
(86) Internationale Anmeldenummer: DE8800085
(87) Internationale Veröffentlichungsnummer: WO8807257

(56) Entgegenhaltungen:
- EP-A- 0 126 169
- WO-A-85/00072
- WO-A-86/00749
- DE-A- 2 054 457

## Beschreibung

### Stand der Technik

Die Erfindung betrifft einen Hochfrequenz-Übertrager gemäß Anspruch 1 oder 2. Aus der DE-OS 33 22 004 ist ein derartiger Hochfrequenz-Übertrager bekannt, der zwei auf einem Isolierträger in Form von gedruckten Leiterbahnen aufgebrachten Spulen aufweist, die um einen geschlossenen Ferritkern herum angeordnet sind. Der Isolierträger besteht aus einem elastischen Werkstoff, der nach seiner Verformung selbsttätig in seine Planlage zurückfedert. In dem Isolierträger sind Aussparungen zur Aufnahme des Ferritkerns sowie in diese mündende Einführungsschlitze für den Kern vorgesehen. Die Aussparungen sind dem Querschnitt des Ringkerns angepaßt, der senkrecht zur im Ringkern verlaufenden Mittellinie gelegt ist. Die Aussparungen begrenzen einen das Kernloch des Ringkerns durchsetzenden Steg, der mit den zwei benachbarten Schlitzen und einem an der Stirnseite des Stegs liegenden Durchbruch eine federnde Zunge bildet, die zum Einführen des Kerns in die Aussparungen aus der Ebene des Isolierträgers aushebbar ist und nach dem Loslassen unter Wirkung der Elastizität in die Planlage zurückfedert, wobei der Steg den Ferritkern in den Aussparungen zentriert und festhält. Zur Vervollständigung der vom Steg unterbrochenen Leiterbahnen auf dem Isolierträger ist eine mit dem Träger verbindbare Brücke vorgesehen, die auf ihrer Unterseite mit Leiterbahnstücken zur Vervollständigung der unterbrochenen Leiterbahnen zu geschlossenen Windungen um den Ringkern belegt ist.

Bei dem bekannten Hochfrequenz-Übertrager gibt es eine Grenze für die erreichbare Hauptinduktivität bei Hochfrequenz. Eine Induktivitssteigerung ist durch Windungszahlerhöhung zwar prinzipiell möglich, aber es muß eine zumeist unerwünschte Zunahme der Streuinduktivität in Kauf genommen werden, weil die Entfernung der auf dem elastischen Träger angeordneten Leiterbahnen vom Kern mit zunehmender Windungszahl zunimmt.

Aus der DE-OS 20 54 457 ist ein Hochfrequenz-Übertrager bekannt, bei dem gemäß einem ersten Ausführungsbeispiel zwei Spulenwicklungen auf der Oberseite eines elastischen Trägers angeordnet sind. Die Spulenwicklungen sind in spiralig verlaufenden kreisförmigen Leiterbahnen nach Art einer gedruckten Schaltung aufgebracht. In der Mitte der beiden Spulen befindet sich im Trägermaterial jeweils ein Loch für die Aufnahme eines Kernplättchens oder eines entsprechenden Kernstiftes aus einem Ferritmaterial. Gemäß einem anderen Ausführungsbeispiel ist es bekannt, den Hochfrequenz-Übertrager durch zwei Spulen zu realisieren, die auf der Ober- und Unterseite des Trägermaterials angeordnet sind. Ein Hochfrequenz-Übertrager mit einem offenen Kern ist bei diesem Ausführungsbeispiel mit einem durch die Spulen sowie durch die Platine gesteckten Ferritstift erreichbar. Ein geschlossener magnetischer Kreis ist mit einem U-förmigen Kern erreichbar, der die Enden des Stiftes magnetisch miteinander verbindet.

Der Erfindung liegt die Aufgabe zugrunde, einen Hochfrequenz-Übertrager anzugeben, der in einem weiten Frequenzbereich nahezu ideale Übertragungseigenschaften aufweist.

Die Aufgabe wird durch die in den unabhängigen Ansprüchen 1 und 2 angegebenen Merkmale gelöst.

### Vorteile der Erfindung

Der erfindungsgemäße Hochfrequenz-Übertrager weist den Vorteil auf, daß eine hohe Hauptinduktivität bei gleichzeitig einer geringen Streuinduktivität erzielbar ist. Besonders vorteilhaft ist mit dem erfindungsgemäßen Hochfrequenz-Übertrager ein Transformator mit einem Windungszahlverhältnis von 1 : 1 realisierbar, wie er beispielsweise für Allpässe benötigt wird. Durch die gegenseitige Überkreuzlage der Primär- und Sekundärwicklung entsteht eine symmetrische Übertragerschaltung mit identischen Wicklungskapazitäten und einer geringen Streuinduktivität, so daß sich damit nahezu ideale Übertrager für beispielsweise Allpaßglieder realisieren lassen. Die Wicklungskapazitäten von der Primär- zur Sekundärwicklung lassen sich einem an den Übertrager anzuschließenden Kondensator zuschlagen. Dadurch hat das reale, beispielhaft genannte Allpaßglied nur die unvermeidlichen ohmschen Verluste und damit die gewünschte minimale Durchgangsdämpfung und die zuvor berechnete Gruppenlaufzeit als Funktion der Frequenz.

Der erfindungsgemäße Hochfrequenz-Übertrager enthält gemäß einer ersten Ausführung mit Leiterbahnen belegte Brücken zum Vervollständigen der von dem durch den Ringkern führenden Steg durchbrochenen Leiterbahnen, wobei auf der Unterseite des untersten Trägers und auf der Oberseite des obersten Trägers jeweils eine Leiterbahnen tragende Brücke vorgesehen ist.

Gemäß einer anderen Ausführung des erfindungsgemäßen Hochfrequenz-Transformators ist vorgesehen, daß die unterste Brücke des Schichtaufbaus fehlt. Diese Maßnahme weist fertigungstechnische Vorteile auf.

Durch die in den Unteransprüchen aufgeführten Maßnahmen sind vorteilhafte Weiterbildungen des in den Ansprüchen 1 oder 2 angegebenen Hochfrequenz-Übrtragers möglich.

Durchkontaktierungen in einzelnen Trägern ermöglichen mit einfachen Mitteln eine Erhöhung der Windungszahl der einzelnen Wicklung oder Teilwicklung durch Fortführung der Wicklung auf einem weiteren Träger.

Eine Ausgestaltung sieht vor, daß in einem Träger eine erste und wenigstens eine zweite Reihe von nebeneinander angeordneten Ringkernen vorgesehen ist. Mit dieser Maßnahme ist eine fertigungstechnisch einfach realisierbare Möglichkeit von mehreren gleichartigen Übertragern möglich.

Eine einfache Realisierung der Träger und der Brücken der Anordnung mit mehreren Ringkernen ist dadurch möglich, daß die freien Enden der aushebbaren Zungen der ersten Reihe und die freien Enden der aushebbaren Zungen der zweiten Reihe im jeweiligen Träger aufeinander zu gerichtet sind. Für den Flächenbereich zwischen den beiden Reihen wird damit nur eine schmale Übertragung benötigt. Der Schichtaufbau und die Zentrierung der einzelnen Schichten zueinander vereinfacht sich dadurch erheblich, weil jeder Arbeitsschritt alle Übertrager gleichzeitig erfaßt.

Eine leichte Montage des Ringkerns ist dadurch möglich, daß die aushebbare Zunge in ihrer Breite in Richtung auf ihr an den Durchbruch grenzendes freies Ende hin abnimmt.

In einer vorteilhaften Ausgestaltung des erfindungsgemäßen Hochfrequenz-Übertragers ist die Summe von Isolationsabständen zwischen den Windungen und von Breiten der Leiterbahnen den Abmessungen von oberflächenmontierbaren Bauelementen (Surface Mounted Devices, SMD) angepaßt. Mit dieser Ausgestaltung ergibt sich die Möglichkeit, vorgegebene, leicht erhältliche SMDs zu verwenden und die Ausgestaltung des Übertragers daran anzupassen. SMDs mit Sonderabmessungen sind somit nicht erforderlich.

Durch die Berücksichtigung von weiteren Bauelementen, die zum Beschalten des erfindungsgemäßen Hochfrequenz-Übertragers vorgesehen sind, können komplette aktive und passive Hochfrequenzschaltungen mit hervorragenden elektrischen Daten kostengünstig realisiert werden. Insbesondere wird eine hohe Betriebsfrequenz bei einer gleichzeitig hohen Packungsdichte der Bauelemente erreicht.

Weitere Einzelheiten und Weiterbildungen des erfindungsgemäßen Hochfrequenz-Übertragers ergeben sich aus weiteren Unteransprüchen in Verbindung mit der folgenden Beschreibung.

### Zeichnung

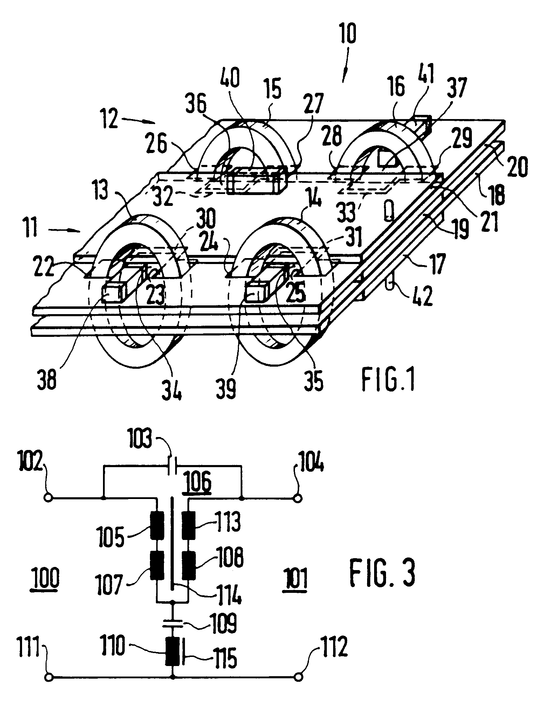

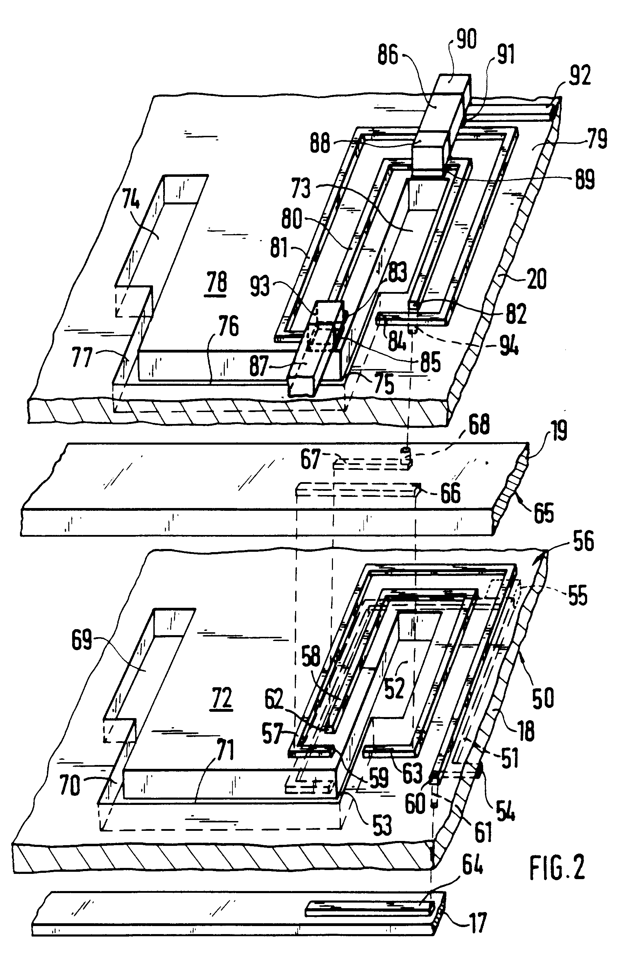

Figur 1 zeigt ein Hochfrequenz-Bauelement in perspektivischer Darstellung, Figur 2 zeigt detailliert den Aufbau eines Teils des Hochfrequenz-Bauelements gemaß Figur 1 und Figur 3 zeigt ein einem erfindungsgemäßen Hochfrequenz-Übertrager zugrundeliegendes Schaltbild.

### Beschreibung der Ausführungsbeispiele

Figur 1 zeigt ein zum erfindungsgemäßen Übertrager hinführendes Hochfrequenz-Bauelement 10 mit einer ersten und einer zweiten Reihe 11, 12 von nebeneinander angeordneten Ringkernen 13, 14, 15, 16. Bei den Ringkernen 13 bis 16 handelt es sich vorzugsweise um Ferrit-Ringkerne, es können jedoch auch andere Kern-formen und Materialien Verwendung finden. Die Kerne 13, 14 der ersten Reihe 11 stehen nicht notwendiger Weise genau den Kernen 15, 16 der zweiten Reihe 12 gegenüber. Ebenso ist die Anordnung in zwei Reihen 11, 12 eine besondere Ausgestaltung, es kann auch eine beliebige andere Verteilung der Kerne vorgesehen sein. Die Kerne 13 bis 16 werden von einem aus mehreren elastischen Folien bestehenden Schichtaufbau zusammengehalten. Der Aufbau beginnt mit einer Brückenfolie 17, gefolgt von einer Trägerfolie 18, auf die wieder eine Brücke 19 und ein Träger 20 usw. folgen. Der Aufbau wird von einer Brücke 21 abgeschlossen. In den Trägern 18, 20 sind Aussparungen 22 bis 29 zur Aufnahme der Kerne 13 bis 16 vorgesehen. Die Größe der Aussparungen 22 bis 29 ist an die Querschnitte der Kerne 13 bis 16 angepaßt. Die Aussparungen 22 bis 29 münden in Durchbrüchen 30 bis 33 in den Trägern 18, 20. Die Kernlöcher der Kerne 13 bis 16 werden von Stegen in den Trägen 18, 20 durchgriffen, die federnde Zungen 34 bis 37 bilden, die zum Einführen der Kerne 13 bis 16 in die Aussparungen 22 bis 29 aus der Ebene der Träger 18, 20 aushebbar sind und nach Loslassen selbsttätig in ihre Planlage zurückfedern. Dadurch werden die Kerne 13 bis 16 nach der Montage unverlierbar in den Aussparungen 22 bis 29 festgehalten, ohne daß es einer zusätzlichen Transportsicherung gegen Herausfallen bedarf. Die Brücken 17, 19, 21 sind in der Art ausgebildet, daß sie über den Durchbrüchen 30 bis 33 sowie über einen aus dem Kernloch herausragenden Teil der Zungen 34 bis 37 zu liegen kommen. Ihre Aufgabe ist es, die durch die Aussparungen 22 bis 29 und die Durchbrüche 30 bis 33 entstandenen Unterbrechungen von Leiterbahnen wieder zu schließen.

Auf dem obersten Träger 20 und der obersten Brücke 21 sind in dem Bereich der Kerne 13 bis 16 SMDs 38 bis 41 vorgesehen. Diese SMDs 38 bis 41 sind mit Leiterbahnen der Spulenwicklungen und anderen Leiterbahnen verbunden. Alle Leiterbahnen sind zugunsten einer besseren Übersichtlichkeit in der Figur 1 nicht dargestellt. Die räumliche Anordnung sowie die Anzahl der Bauelemente 38 bis 41 ist willkürlich gewählt.

Alle Träger und Brücken 17 bis 21 werden an einem Ende des Hochfrequenz-Bauelements 10 von einem Zentrierstift 42 fixiert. An einem in Figur 1 nicht gezeigten zweiten Ende des Hochfrequenz-Bauelements 10 ist ein weiterer Zentrierstift zur Fixierung der Folien 17 bis 21 vorgesehen. Der gesamte Schichtaufbau wird demnach von nur zwei Fixierstiften 42 ausgerichtet.

Figur 2 zeigt als Vorstufe des erfindungsgemäßen Übertragers detailliert einen Ausschnitt des Schichtaufbaus des Hochfrequenz-Bauelements 10 gemäß Figur 1 im Bereich eines der Kerne 13 bis 16. In den Figuren 1 und 2 sind dieselben Teile mit den gleichen Bezugszeichen versehen. Auf der Unterseite 50 des Trägers 18 ist flächenhaft eine Leiterbahn 51 aufgebracht die um eine Aussparung 52 und einen Durchbruch 53 im Träger 18 herum rechteckig ausgeführt ist und die ein Anschlußstück 54 aufweist. Im Verlauf der Leiterbahn 51 befindet sich auf der Unterseite 50 eine Kontaktierungsstelle 55 für ein SMD, das auf der Unterseite 50 des Trägers 18 angeordnet ist. Auf der Oberseite 56 des Trägers 18 sind zwei Leiterbahnen 57, 58 in rechteckiger Form um die Aussparung 52 herum flächig angeordnet. Die Leiterbahn 57 weist ein erstes und zweites Ende 59, 60 auf. An dem einen Ende 60 ist eine Durchkontaktierung 61 zur Unterseite 50 des Trägers 18 vorgesehen. Die Leiterbahn 58 weist ein Leiterbahnende 62 und ein Leiterbahnende 63 auf. Aus den Leiterbahnen 51, 57, 58 entstehen Windungen durch die auf den Brücken 17, 19 angeordneten Leiterstücke, die den Durchbruch 53 überbrücken. Auf der Brücke 17 ist ein Leiterstück 64 vorgesehen, das die auf der Unterseite 50 des Trägers 18 befindliche Leiterbahn 51 über den Durchbruch 53 hinweg verlängert. Damit, ausgehend von dem Anschlußstück 54 der Leiterbahn 51, eine geschlossene Wicklung entstehen kann, ist die Durchkontaktierung 61 zur Leiterbahn 57 auf der Oberseite 56 des Trägers 18 vorgesehen, die mit dem Leiterstück 64 auf der Brücke 17 kontaktiert wird.

Auf der Unterseite 65 der Brücke 19 ist ein erstes und zweites Leiterstück 66, 67 angeordnet. Das erste Leiterstück 66 verbindet das Leiterbahnende 59 des Leiters 57 mit dem Leiterbahnende 63 des Leiters 58 auf dem Träger 18. Das zweite Leiterstück 67 verbindet das Leiterbahnende 62 der Leiterbahn 58 über eine Durchkontaktierung 68 in der Brücke 19 mit Leiterbahnen, die auf dem zweiten Träger 20 angeordnet sind.

Bevor die Brücken 17, 19 mit den Trägern 18 in Kontakt gebracht werden, wird in den Träger 18 ein in Figur 2 nicht gezeigter Kern 13 bis 16 in die Aussparung 52 sowie in eine Aussparung 69 eingebracht. Hierzu wird eine von den Aussparungen 52, 69 und von Durchbrüchen 53, 70, 71 begrenzte, aushebbare Zunge 72 aus der Ebene des Trägers 18 soweit herausgehoben, daß der Ringkern 13 bis 16 eingeführt werden kann. Nachdem die aushebbare Zunge 72 durch die Elastizität des Folienmaterials des Trägers 18 zurückgefedert ist, ist der Kern unverlierbar eingeschlossen. Danach erfolgt die Aufbringung der Brücken 17 auf die Unterseite 50 bzw. der Brücken 19 auf die Oberseite 56 des Trägers 18, beispielsweise mittels Thermokompression oder durch Löten.

Um den Durchbruch 69 herum sind aus Vereinfachungsgründen keine Leiterbahnen eingezeichnet. Hier kann dieselbe oder eine ähnliche Leiterbahnstruktur vorgesehen sein, wie sie um die Aussparung 52 herum angeordnet ist.

Der Schichtaufbau wird mit dem Träger 20 fortgesetzt. Aussparungen 73, 74 und Durchbrüche 75, 76, 77 begrenzen auch in diesem Träger 20 eine aushebbare Zunge 78. Die Ringkerne 13 bis 16 werden über die Zunge 78 geschoben, die aus der Ebene herausgehoben ist.

Der Träger 20 weist auf seiner Oberseite 79 eine Leiterbahnstruktur auf, bestehend aus einer ersten Leiterbahn 80 und einer zweiten Leiterbahn 81. Beide Leiterbahnen 80, 81 sind rechteckförmig um die Aussparung 73 und den Durchbruch 75 im Träger 20 herum angeordnet. Die erste Leiterbahn 80 weist ein erstes Leiterbahnende 82 und ein zweites Leiterbahnende 83 auf. Die zweite Leiterbahn 81 weist ein erstes Leiterbahnende 84 und ein zweites Leiterbahnende 85 auf. Weiterhin sind auf der Oberfläche 79 des Trägers 20 SMDs 86, 87 vorgesehen. Ein erstes SMD 86 ist mit einem seiner Anschlußstücke 88 mit der ersten Leiterbahn 80 verbunden, die zu diesem Zweck eine Kontaktierungsstelle 89 aufweist. Das andere Anschlußstück 90 des SMDs 86 steht über eine Kontaktierungsstelle 91 in Verbindung mit einer weiteren auf der Oberfläche 79 angeordneten Leiterbahn 92. Das andere SMD 87 ist mit einem seiner Anschlußstücke 93 mit der zweiten Leiterbahn 81 verbunden, deren zweites Leiterbahnende 85 zu diesem Zweck als Kontaktierungsstelle ausgebildet ist.

Eine Weiterführung der Windungen um den Kern 13 bis 16 mit den Leiterbahnen auf dem Träger 18, 20 wird erhalten mit einer am ersten Leiterbahnende 82 des ersten Leiters 80 vorgesehenen Durchkontaktierung 94 durch den Träger 20, die eine Verbindung zu der Durchkontaktierung 68 in der Brücke 19 herstellt. Die erste Leiterbahn 80 stellt somit einen Teil der ersten Windung auf dem Träger 20 dar. Eine geschlossene Wicklung wird erhalten, wenn das zweite Leiterbannende 83 des ersten Leiters 80 mit dem ersten Leiterbahnende 84 der zweiten Leiterbahn 81 verbunden wird. Dazu ist die Brücke 21 vorgesehen, die in Figur 2 nicht mehr gezeigt ist. Auf dieser Brücke 21 befinden sich Verbindungsleiterstücke in gleicher Weise wie sie auf der Brücke 19 mit den darauf angeordneten Leiterstücken 66, 67 ausgeführt sind. Gegebenenfalls sind in der Brücke 21 Aussparungen für die SMDs 86, 87 vorzusehen.

Zur weiteren Windungs- und damit Induktivitätserhöhung können weitere Brücken und Träger wechselweise geschichtet vorgesehen sein, bis die erforderliche Windungszahl erreicht ist. In dem gezeigten Ausführungsbeispiel gemäß Figur 2 sind auf den Trägern 18, 20 jeweils in einer Ebene nebeneinander zwei Leiterbahnen 57, 58 bzw. 80, 81 angeordnet. Prinzipiell sind auch mehrere nebeneinander liegende Leiterbahnen möglich, jedoch muß dann mit einer kleinen Zunahme der Streuinduktivität der Spule gerechnet werden, da die von den Aussparungen 52, 69 bzw. 73, 74 weiter entfernt liegenden Leiterbahnen ein magnetisches Streufeld im Außenbereich der Kerne 13 bis 16 erzeugen.

Figur 3 zeigt ein dem erfindungsgemäßen Hochfrequenz-Übertrager zugrundeliegendes Schaltbild, hier als Beispiel einen Allpaß, für dessen Realisierung sich: der erfindungsgemäße Hochfrequenz Übertrager in besonderer Weise eignet. Der Allpaß verzögert ein an seinem Eingang 100 liegendes Eingangssignal an seinem Ausgang 101 um einen frequenzabhängigen Betrag. Eine Dämpfung des Signals tritt im Idealfall nicht auf. Die frequenzabhängige Phasenverschiebung zwischen Ein- und Ausgangssignal ist gleichbedeutend mit einer frequenzabhängigen Signallaufzeit, womit der Allpaß zur Laufzeitentzerrung von Signalen eingesetzt werden kann.

Der erste Eingangsanschluß 102 ist verbunden mit einem Kondensator 103, der zum ersten Ausgangsanschluß 104 führt, und mit dem ersten Teil 105 der Primärwicklung 105 eines Übertragers 106. Der zweite Teil der Primärwicklung 107 ist mit einem ersten Teil der Sekundärwicklung 108 sowie über eine aus einem Kondensator 109 und einer Spule 110 bestehenden Reihenschaltung mit dem zweiten Eingangsananschluß 111 und dem zweiten Ausgangsanschluß 112 verbunden. Der erste Teil der Sekundärwicklung 108 ist über den zweiten Teil der Sekundärwicklung 113 mit dem ersten Ausgangsanschluß 104 verbunden. Der Übertrager 106 enthält einen Kern 114, der beispielsweise einer der Kerne 13 bis 16 ist. Der in Figur 3 gezeigte Allpaß kann vorteilhaft mit dem in Figur 2 gezeigten Schichtaufbau realisiert werden. Der erste Teil der Primärwicklung 105 ist beispielsweise durch die Leiterbahnen 51, 57, 58 auf dem Träger 18 realisiert. Der zweite Teil der Primärwicklung 107 wird dann um die Aussparung 69 und den Durchbruch 70 herum angeordnet. Der erste Teil der Sekundärwicklung 108 wird beispielsweise durch die Leiterbahnen 80, 81 auf dem Träger 20 realisiert und der zweite Teil der Sekundärwicklung 113 durch Leiterbahnen, die um die Aussparung 74 und den Durchbruch 77 herum angeordnet. Diese spezielle Aufteilung der Primär- und Sekundärwicklung des Übertragers 108 bedeutet eine räumliche Zuordnung des ersten Teils der Primärwicklung 105 zum zweiten Teil der Sekundärwicklung 113 bzw. des zweiten Teils der Primärwicklung 107 zum ersten Teil der Sekundärwicklung 108. Durch die gegenseitige Überkreuzlage der Primär- und Sekundärwicklung entsteht eine symmetrische Übertragerschaltung mit identischen Wicklungskapazitäten und einer geringen Streuinduktivität, so daß sich damit nahezu ideale Übertrager realisieren lassen. Die Wicklungskapazität von der Primär- zur Sekundärwicklung läßt sich bei dem Allpaßglied gemäß Figur 3 dem Kondensator 103 zurechnen. Dadurch hat das reale Allpaßglied nur die unvermeidlichen ohmschen Verluste und damit die gewünschte minimale Durchgangsdämpfung und die zuvor berechnete Phasenverschiebung bzw. Gruppenlaufzeit als Funktion der Frequenz. Die beiden Kondensatoren 103, 109 sind beispielsweise die in Figur 2 gezeigten SMDs 86, 87. Die Anschlußpunkte mit den Kontaktierungsstellen 85, 89 sind in Figur 2 nur exemplarisch eingezeichnet und stimmen mit den tatsächlichen Anschlüssen der Kondensatoren 103, 109 aus Figur 3 nicht überein. Die Spule 110 enthält eine Kern 115, der einer der Kerne 13 bis 16 ist.

Die Leiterbahnstrukturen lassen sich zum Erreichen von besonderen elektrischen Eigenschaften modifizieren. Beispielsweise ist auch die Leiterbahnbreite mit zunehmender Windungszahl erhöhbar, so daß die ohmschen Verluste durch die verlängerte Leitungsführung nicht weiter erhöht werden. In bestimmten Bereichen, insbesondere dort, wo SMDs 86, 87 vorgesehen sind, ist die geometrische Aufteilung der Leiterbahnen in der Ebene den Abmessungen der SMDs 86, 87 anzupassen. Dazu kann beispielsweise die Summe von den Isolationsabständen zwischen den Windungen und von den Breiten der Leiterbahnen vorgegeben werden.

Eine Modifizierung der Anordnung gemäß Figur 2 ist dadurch gegeben, daß die Durchbrüche 53, 70 bzw. 75, 77 nicht mehr parallel zueinander angeordnet sind, sondern einen solchen Verlauf haben, daß die Breite der von Durchbrüchen 53, 70 bzw. 75, 77 begrenzten Abschnitte der Zungen 72, 78 in Richtung auf die Durchbrüche 71 bzw. 77 hin abnimmt. Diese Formgebung der Zungen 72, 78 erleichtert die Einführung der Kerne 13 bis 16, weil der Zungenanfang wesentlich schmaler ist als der Lochdurchmesser der Kerne.

Der vorgeschlagene Hochfrequenz-Übertrager ist nicht nur zur Halterung von Einlochkernen, sondern auch von Mehrlochkernen geeignet. Hierbei wird jedes Kernloch von einer federnden Zunge durchgriffen, die gleiche oder ähnliche Form haben kann wie die in den Figuren 1 und 2 gezeigten Zungen 34 bis 37, 72, 78. Mit dem erfindungsgemäßen Hochfrequenz-Übertrager lassen sich somit auch lineare Netzwerke realisieren, die komplizierte Übertrager strukturen enthalten.

## Patentansprüche

1. Hochfrequenz-Übertrager (106) mit den Merkmalen:
a) es ist wenigstens ein Ringkern (13, 14, 15, 16) vorgesehen;
b) es ist ein erster elastischer Träger (18) vorgesehen, dessen Ober- und Unterseite (50, 56) mit Leiterbahnen (51, 57, 58) belegt sind;
c) es ist wenigstens ein weiterer elastischer Träger (20) vorgesehen, dessen Oberseite (79) mit Leiterbahnen (80, 81, 92) belegt ist;
d) die Leiterbahnen (51, 57, 58, 80, 81, 92) sind wenigstens um Aussparungen (52, 69, 73, 74) herum angeordnet;
e) die Aussparungen (52, 69, 73, 74) sind dem Querschnitt des Ringkerns (13-16) angepaßt, der senkrecht zur im Ringkern (13-16) verlaufenden Mittellinie gelegt ist;
f) die Aussparungen (52, 69, 73, 74) begrenzen je einen das Kernloch des Ringkerns (13 - 16) durchsetzenden Steg (72, 78) der Träger (18, 20) und münden anschließend in Durchbrüche (53, 70, 71, 75, 76, 77) der Träger (18, 20), derart, daß der jeweilige Steg (72, 78) eine federnde, aushebbare Zunge zum Einführen des Ringkerns (13 - 16) in die Aussparungen (52, 69, 73, 74) bildet;
g) auf der Unterseite (50) und der Oberseite (56) des ersten elastischen Trägers (18) ist jeweils eine mit diesem Träger (18) verbindbare Brücke (17, 19) vorgesehen, die jeweils mit Leiterbahnstücken (64, 66, 67) zur Vervollständigung der Leiterbahnen (51, 57, 58) zu geschlossenen Windungen um den Ringkern (13 - 16) belegt ist;
h) es ist eine mit der Oberseite (79) des weiteren elastischen Trägers (20) verbindbare Brücke (21) vorgesehen, die mit Leiterbahnstücken zur Vervollständigung der Leiterbahnen (80, 81) zu geschlossenen Windungen um den Ringkern (13 - 16) belegt ist;
i) ein erster Teil (105) der Primärwicklung des Übertragers (106) und ein erster Teil (108) Sekundärwicklung des Übertragers (106) sind um die jeweilige eine Aussparung (52, 73) in den Trägern (18, 20) herum angeordnet;
j) ein zweiter Teil (107) der Primärwicklung und ein zweiter Teil (113) der Sekundärwicklung des Übertragers (106) sind um die jeweilige andere Aussparung (69, 74) in den Trägern (18, 20) herum angeordnet.

2. Hochfrequenz-Übertrager (106) mit den Merkmalen:
a) Es ist wenigstens ein Ringkern (13, 14, 15, 16) vorgesehen;
b) es sind wenigstens zwei elastische Träger (18, 20) vorgesehen;
c) auf den Oberseiten (56, 59) der Träger (18, 20) sind jeweils Leiterbahnen (57, 58, 80, 81, 92) aufgebracht;
d) die Leiterbahnen (57, 58, 80, 81, 92) sind wenigstens um Aussparungen (52, 69, 73, 74) herum angeordnet;
e) die Aussparungen (52, 69, 73, 74) sind dem Querschnitt des Ringkerns (13 - 16) angepaßt, der senkrecht zur im Ringkern (13 -16) verlaufenden Mittellinie gelegt ist;
f) die Aussparungen (52, 69, 73, 74) begrenzen jeweils das Kernloch des Ringkerns (13 - 16) durchsetzende Stege (72, 78) der Träger (18, 20), die anschließend in Durchbrüche (53, 70, 71, 75, 76, 77) münden, derart, daß die Stege (72, 78) jeweils federnde, aushebbare Zungen zum Einführen des Ringkerns (13 - 16) in die Aussparungen (52, 69, 73, 74) bilden;
g) es ist jeweils eine mit einem der Träger (18, 20) verbindbare Brücke (19, 21) vorgesehen, die auf ihrer Unterseite (65) mit Leiterbahnstücken (66, 67) zur Vervollständigung der Leiterbahnen (57, 58, 80, 81) zu geschlossenen Windungen um den Ringkern (13 - 16) belegt ist;
h) ein erster Teil (105) der Primärwicklung des Übertragers (106) und ein erster Teil (108) der Sekundärwicklung des Übertragers (106) sind um die jeweilige eine Aussparung (52, 73) in den Trägern (18, 20) herum angeordnet;
i) ein zweiter Teil (107) der Primärwicklung und ein zweiter Teil (113) der Sekundärwicklung des Übertragers (106) sind um die jeweilige andere Aussparung (69, 74) in den Trägern (18, 20) herum angeordnet.

3. Übertrager nach Anspruch 1 oder 2, dadurch gekennzeichnet, daß im jeweiligen Träger (18, 20) wenigstens eine Durchkontaktierung (61, 94) vorgesehen ist.

4. Übertrager nach einem der Ansprüche 1 oder 2, dadurch gekennzeichnet, daß in der zwischen den Trägern (18, 20) liegenden Brücke (19) wenigstens eine Durchkontaktierung (68) vorgesehen ist.

5. Übertrager nach einem der vorhergehenden Ansprüche, dadurch gekennzeichnet, daß in einem der Träger (18, 20) eine erste und wenigstens eine zweite Reihe (11, 12) von nebeneinander angeordneten Ringkernen (13, 14 bzw. 15, 16) vorgesehen ist.

6. Übertrager nach Anspruch 5, dadurch gekennzeichnet, daß die freien Enden der aushebbaren Zungen (34, 35) der ersten Reihe (11) und die freien Enden der aushebbaren Zungen (36, 37) der zweiten Reihe (12) im jeweiligen Träger (18, 20) aufeinander zu gerichtet sind.

7. Übertrager nach einem der vorhergehenden Ansprüche, dadurch gekennzeichnet, daß die aushebbare Zunge (34 - 37, 72, 78) in ihrer Breite in Richtung auf ihr an den Durchbruch (71, 76) grenzendes freies Ende (34 - 37, 72, 78) hin abnimmt.

8. Übertrager nach einem der vorhergehenden Ansprüche, dadurch gekennzeichnet, daß die Träger (18, 20) und die Brücken (17, 19, 21) durch wenigstens zwei Fixierstifte (42) gegeneinander positioniert sind.

9. Übertrager nach einem der vorhergehenden Ansprüche, dadurch gekennzeichnet, daß auf den Trägern (18, 20) und/oder Brücken (17, 19, 21) Kontaktierungsstellen (85, 89) für oberflächenmontierbare Bauelemente (38 bis 41, 86, 87) vorgesehen sind.

10. Übertrager nach Anspruch 9, dadurch gekennzeichnet, daß die Summe von Isolationsabständen zwischen den Leiterbahnen (57, 58 bzw. 80, 81, 92) und von Breiten der Leiterbahnen (57, 58 bzw. 80, 81, 92) den Abmessungen der oberflächenmontierbaren Bauelemente (38 bis 41, 86, 87) angepaßt ist.

## Claims

1. High-frequency repeating coil (106) having the features:
a) at least one annular core (13, 14, 15, 16) is provided;
b) a first elastic carrier (18) is provided whose topside and underside (50, 56) are laid with conductor tracks (51, 57, 58);
c) at least one further elastic carrier (20) is provided whose topside (79) is laid with conductor tracks (80, 81, 92);
d) the conductor tracks (51, 57, 58, 80, 81, 92) are arranged at least around openings (52, 69, 73, 74);
e) the openings (52, 69, 73, 74) are adjusted to the cross-section of the annular core (13 - 16), which is laid perpendicular to the centre line extending in the annular core (13-16);
f) the openings (52, 69, 73, 74) each delimit a strip (72, 78) of the carriers (18, 20) passing through the core hole of the annular core (13 - 16), and subsequently end in cutouts (53, 70, 71, 75, 76, 77) of the carriers (18, 20) in such a way that the respective strip (72, 78) forms an elastic tongue, which can be removed in order to introduce the annular core (13 - 16) into the openings (52, 69, 73, 74);
g) provided in each case on the underside (50) and the outside (56) of the first elastic carrier (18) is a bridge (17, 19) which can be connected to this carrier (18) and is laid with conductor track parts (64, 66, 67) for completing the conductor tracks (51, 57, 58) as closed turns around the annular core (13 - 16);
h) there is provided a bridge (21) which can be connected to the topside (79) of the further elastic carrier (20) and which is laid with conductor track parts for completing the conductor tracks (80, 81) as closed turns around the annular core (13 - 16);
i) a first part (105) of the primary of the repeating coil (106) and a first part (108) of the secondary of the repeating coil (106) are arranged around the respective one opening (52, 73) in the carriers (18, 20);
j) a second part (107) of the primary and a second part (113) of the secondary of the repeating coil (106) are arranged around the respective other openings (69, 74) in the carriers (18, 20).

2. High-frequency repeating coil (106) having the features:
a) at least one annular core (13, 14, 15, 16) is provided;
b) at least two elastic carriers (18 or 20) are provided;
c) conductor tracks (57, 58, 80, 81, 92) are applied in each case to the topsides (56, 59) of the carriers (18, 20);
d) the conductor tracks (57, 58, 80, 81, 92) are arranged at least around openings (52, 69, 73, 74);
e) the openings (52, 69, 73, 74) are adjusted to the cross-section of the annular core (13 - 16), which is laid perpendicular to the centre line extending in the annular core (13 - 16);
f) the openings (52, 69, 73, 74) in each case delimit strips (72, 78) of the carriers (18, 20) passing through the core hole of the annular core (13 - 16), which subsequently end in cutouts (53, 70, 71, 75, 76, 77) in such a way that the strips (72, 78) in each case form elastic, removable tongues for inserting the annular core (13 - 16) into the openings (52, 69, 73, 74);
g) there is provided in each case a bridge (19, 21) which can be connected to one of the carriers (18, 20) and is laid on its underside (65) with conductor track parts (66, 67) for completing the conductor tracks (57, 58, 80, 81) as closed turns around the annular core (13 - 16);
h) a first part (105) of the primary of the repeating coil (106) and a first part (108) of the secondary of the repeating coil (106) are arranged around the respective one opening (52, 73) in the carriers (18, 20);
i) a second part (107) of the primary and a second part (113) of the secondary of the repeating coil (106) are arranged around the respective other opening (69, 74) in the carriers (18, 20).

3. Repeating coil according to Claim 1, characterised in that at least one feedthrough (61, 94) is provided in the respective carrier (18, 20).

4. Repeating coil according to one of Claims 1 or 2, characterised in that at least one feedthrough (68) is provided in the bridge (19) lying between the carriers (18, 20).

5. Repeating coil according to one of the preceding claims, characterised in that there is provided in one of the carriers (18, 20) a first and at least a second row (11, 12) of annular cores (13, 14 or 15, 16) arranged next to one another.

6. Repeating coil according to Claim 5, characterised in that the free ends of the removable tongues (34, 35) of the first row (11) and the free ends of the removable tongues (36, 37) of the second row (12) are aligned towards one another in the respective carrier (18, 20).

7. Repeating coil according to one of the preceding claims, characterised in that the removable tongue (34 - 37, 72, 78) reduces in width in the direction of its free end (34-37, 72, 78) which abuts the cutout (71, 76).

8. Repeating coil according to one of the preceding claims, characterised in that the carriers (18, 20) and the bridges (17, 19, 21) are located in relation to one another by at least two alignment pins (42).

9. Repeating coil according to one of the preceding claims, characterised in that there are provided on the carriers (18, 20) and/or bridges (17, 19, 21) bonding pads (85, 89) for surface-mounted devices (38 to 41, 86, 87).

10. Repeating coil according to Claim 9, characterised in that the sum of insulation spacings between the conductor tracks (57, 58 or 80, 81, 92) and the widths of the conductor tracks (57, 58 or 80, 81, 92) is adjusted to the dimensions of the surface mounted devices (38 to 41, 86, 87).

## Revendications

1. Transformateur haute fréquence (106) caractérisé par les points suivants :
a) il est muni d'au moins un noyau annulaire (13, 14, 15, 16) ;
b) il est doté d'un support élastique (18) dont les surfaces inférieures et supérieures (50, 56) sont occupées par des bandes conductives (51, 57, 58) ;
c) il est doté d'un autre support élastique (20) dont la surface supérieure (79) est occupée par des bandes conductives (80, 81, 92) ;
d) les bandes conductives (51, 57, 58, 80, 81, 92) sont situées autour des découpes (52, 69, 73, 74) ;
e) les découpes (52, 69, 73, 74) sont adaptées à la section des noyaux annulaires, perpendiculairement à la ligne d'axe passant par les noyaux annulaires (13-16) ;
f) les découpes (52, 69, 73, 74) délimitent chacune au moins une entretoise (72, 78) des supports (18, 20) traversant l'orifice du noyau annulaire (13-16) et ces découpes débouchent alors dans des passages (53, 70, 71, 75, 76, 77) des supports (18, 20) de façon que l'entretoise respective (72, 78) forme une languette élastique qui peut être levée pour introduire le noyau annulaire (13-16) dans les découpes (52, 69, 73, 74) ;
g) sur la face inférieure (52) et la face supérieure (56) du premier support élastique (18), il est prévu chaque fois un pont (17, 19) relié à ce support (18), le pont étant chaque fois muni de parties de chemins conducteurs (64, 66, 67) pour compléter les chemins conducteurs (51, 57, 58) vers les enroulements fermés autour des anneaux (13-16) ;
h) il est prévu un pont (21) susceptible d'être relié à la face supérieure (79) de l'autre support élastique (20), ce pont étant occupé par des parties de chemins conducteurs pour compléter les chemins conducteurs (80, 81) et former des spires fermées entourant les noyaux annulaires (13-16) ;
i) une première partie (105) de l'enroulement primaire du transformateur (106) et une première partie (108) de l'enroulement secondaire du transformateur (106) sont placées autour chaque fois d'une cavité (52, 73) des supports (18, 20) ;
j) une seconde partie (107) de l'enroulement primaire et une seconde partie (113) de l'enroulement secondaire du transformateur (106) sont prévues chaque fois autour de l'autre cavité (69, 74) dans les supports (18, 20).

2. Transformateur haute fréquence (106) caractérisé par les points suivants :
a) il comporte au moins un noyau annulaire (13, 14, 15, 16) ;
b) il comporte au moins deux supports élastiques (18, 20) ;
c) sur la face supérieure (56, 59) des supports (18, 20) il y a chaque fois des chemins conducteurs (57, 58, 80, 81, 92) ;
d) les chemins conducteurs (57, 58, 80, 81, 92) sont disposés au moins autour d'une cavité (52, 69, 73, 74) ;
e) les découpes (52, 69, 73, 74) sont adaptées à la section du noyau annulaire (13-16) perpendiculairement à la ligne d'axe passant par le noyau annulaire (13-16) ;
f) les découpes (52, 69, 73, 74) délimitent chacune l'entretoise (72, 78) des supports (18, 20) traversant l'orifice du noyau annulaire (13-16), ces supports débouchant alors dans des passages (53, 70, 71, 75, 76, 77) de façon que les entretoises (72, 78) forment chacune une languette élastique susceptible d'être relevée pour introduire le noyau annulaire (13-16) dans les découpes (52, 69, 73, 74) ;
g) il est prévu un pont (19, 21) susceptible d'être relié à l'un des supports (18, 20), le pont étant occupé sur sa face inférieure (65) par des parties de chemins conducteurs (66, 77) pour compléter les chemins conducteurs (57, 58, 80, 81) pour constituer des enroulements fermés autour des noyaux annulaires (13-16) ;
h) une première partie (105) de l'enroulement primaire du transformateur (106) et une première partie (108) de l'enroulement secondaire du transformateur (106) sont disposées chaque fois autour d'une cavité (52, 73) dans les supports (18, 20) ;
i) une seconde partie (107) de l'enroulement primaire et une seconde partie (113) de l'enroulement secondaire du transformateur (106) sont placées autour de l'autre cavité respective (69, 74) dans les supports (18, 20) ;

3. Transformateur selon la revendication 1 ou 2, caractérisé par au moins un contact traversant (61, 94) dans chaque support (18, 20).

4. Transformateur selon l'une des revendications 1 ou 2, caractérisé en ce que le pont (19) prévu entre les supports (18, 20), il y a au moins un contact traversant (68).

5. Transformateur selon l'une des revendications précédentes, caractérisé en ce que l'un des supports (18, 20) comporte une première et au moins une seconde rangée (11, 12) de noyaux annulaires (13, 14) ou (15, 16) juxtaposés.

6. Transformateur selon la revendication 5, caractérisé en ce que les extrémités libres des languettes relevables (34, 35) de la première rangée (11) et les extrémités libres des languettes relevables (36, 37) de la seconde rangée (12) sont alignées les unes sur les autres dans les supports respectifs (18, 20).

7. Transformateur selon l'une des revendications précédentes, caractérisé en ce que la languette extractible (34-37, 72, 78) diminue suivant sa largeur en direction de l'extrémité libre (34-37, 72, 78) adjacent au passage (71, 76).

8. Transformateur selon l'une des revendications précédentes, caractérisé en ce que les supports (18, 20) et les ponts (17, 19, 21) sont positionnés l'un par rapport à l'autre par au moins deux tiges de fixation (42).

9. Transformateur selon l'une des revendications précédentes, caractérisé par des points de contact (85, 89) sur les supports (18, 20) et/ou les ponts (17, 19, 21) pour des composants susceptibles d'être montés en surface (38-41, 86, 87).

10. Transformateur selon la revendication 9, caractérisé en ce que la somme des intervalles d'isolation entre les chemins conducteurs (57, 58 ou 80, 81, 92) et des largeurs des chemins conducteurs (57, 58, et 80, 81, 92) est adaptée aux dimensions des composants (38-41, 86, 87) susceptibles d'être montés en surface.
